# EUROPÄISCHE PATENTSCHRIFT

(11) **EP 3 171 495 B1**
(45) Veröffentlichungstag und Bekanntmachung des Hinweises auf die Patenterteilung: **25.04.2018**
(21) Anmeldenummer: 16002319.8
(22) Anmeldetag: 31.10.2016
(51) Int. Cl.: H02K 15/14, G01R 31/34

(54) **VERFAHREN ZUR MONTAGE VON ANBAUTEILEN AN EINER ELEKTRISCHEN MASCHINE**
METHOD FOR MOUNTING ATTACHMENTS ON AN ELECTRICAL MACHINE
PROCÉDÉ DE MONTAGE D'ÉLÉMENTS RAPPORTÉS SUR UNE MACHINE ÉLECTRONIQUE

(30) Priorität: 18.11.2015 DE 102015014942
(43) Veröffentlichungstag der Anmeldung: 24.05.2017
(73) Patentinhaber: AUDI AG, 85045 Ingolstadt (DE)
(72) Erfinder: Schmidt, Jörg, DE - 85057 Ingolstadt (DE)
(74) Vertreter: Eickmeyer, Dietmar

(56) Entgegenhaltungen:
- WO-A1-2012/040536
- GB-A- 1 341 434
- US-A- 5 786 646
- US-A1- 2007 090 719

## Beschreibung

Verfahren zur Montage von Anbauteilen an einer elektrischen Maschine Die Erfindung betrifft ein Verfahren zur Montage von Anbauteilen an einer einen Stator und einen Rotor aufweisenden elektrischen Maschine gemäß dem Oberbegriff des Patentanspruchs 1.

Elektrische Maschinen weisen einen Stator und einen Rotor auf, der sich relativ zu dem Stator dreht. Elektrische Maschinen können als Motor, als Generator oder wahlweise sowohl als Motor als auch als Generator betrieben werden. Bei der Montage derartiger elektrischen Maschinen müssen nach deren Komplettierung mit Stator, Rotor, Lagern und Gehäuseteilen verschiedene Anbauteile, wie zum Beispiel Kühlsysteme, Leistungselektroniken und Verkabelungen verbaut werden.

Aus Gründen der Ergonomie wird angestrebt, die elektrische Maschine so zu positionieren, dass die Fügerichtung des Anbauteiles in Richtung von deren Schwerkraft verläuft und dadurch die Anbauteile von oben montiert werden können.

Für solche Montagarbeiten werden Drehtische verwendet, die eine um eine Aufnahmeachse dreh- und/oder schwenkbare Werkstückaufnahme aufweisen. Mittels eines Antriebs kann die Werkstückaufnahme in jede erforderliche Dreh- oder Winkelstellung gebracht werden. Ein solcher Drehtisch ist bspw. aus der DE 10 2013 109 307 A1 bekannt.

Ein gattungsbildendes Verfahren zum Wechseln von Statormodulen eines Stators einer elektrischen Maschine im Rahmen von Wartungsarbeiten an dieser Maschine ist aus der WO 2012/040536 A1 bekannt. Zur Durchführung dieses Verfahrens wird ein Statormodul-Wechselwerkzeug mit einer Einsetz/Entnahme-Einrichtung bereitgestellt. Dieses Statormodul-Wechselwerkzeug wird mit einem Rotor der Maschine drehfest verbundenen und durch Bestromung der Maschine der Rotor in eine bestimmte Position verdreht, das Statormodul-Wechselwerkzeug in dieser Position des Rotors mit einem Statorgehäuse verbunden und anschließend das dieser Position zugeordnete Statormodul mittels der Einsetz/Entnahme-Einrichtung ausgewechselt.

Es ist Aufgabe der Erfindung ein Verfahren zur Montage von Anbauteilen an einer elektrischen Maschine anzugeben, bei dem auf den Einsatz eines Drehtisches verzichtet werden kann.

Diese Aufgabe wird gelöst durch ein Verfahren mit den Merkmalen des Patentanspruchs 1.

Ein solches Verfahren zur Montage von Anbauteilen an einer einen in einem Statorgehäuse angeordneten Stator und einen Rotor aufweisenden elektrischen Maschine zeichnet sich erfindungsgemäß dadurch aus, dass
- die elektrische Maschine auf eine Montageeinrichtung montiert wird, indem der Rotor drehfest mit einer Lagervorrichtung der Montageeinrichtung verbunden wird,
- zum Montieren wenigstens eines Anbauteiles der Stator über das Statorgehäuse mittels einer Klemmeinrichtung der Montageeinrichtung in einer vorgegebenen Montageposition lösbar fixiert wird,
- das Anbauteil an dem Stator montiert wird,
- zum Montieren wenigstens eines weiteren Anbauteils in einer weiteren Montageposition die Klemmeinrichtung gelöst und die elektrische Maschine mit einer solchen Zeitdauer als Motor betrieben wird, bis der Stator zusammen mit dem Statorgehäuse durch Rotation gegenüber dem mit der Lagervorrichtung drehfest verbundenen Rotor die weitere Montageposition erreicht hat,
- der Stator über das Statorgehäuse in der weiteren Montageposition mittels der Klemmeinrichtung fixiert wird, und
- das weitere Anbauteil an dem Stator montiert wird.

Bei diesem erfindungsgemäßen Verfahren kann über die Bestromungsdauer jede beliebige Lage des Stators als dessen Montageposition relativ zum Rotor eingestellt werden, insbesondere solche Montagepositionen, die hinsichtlich des zu montierenden Anbauteils zu einer Fügerichtung in Richtung von dessen Schwerkraft bzw. Gewichtskraft führen. Dies wird dadurch erreicht, dass der Rotor der elektrischen Maschine, bspw. über die Rotorachse drehfest gelagert wird und infolgedessen bei einer Bestromung des Stators, d.h. bei Bestromung der Statorwicklungen der Stator gegenüber dem Rotor in eine Rotation versetzt wird. Hat der Stator die gewünschte Montageposition erreicht, wird die Bestromung der Statorwicklungen beendet und der Stator in dieser Lage fixiert. Nun kann in dieser fixierten Montageposition das Anbauteil montiert werden. Damit ist kein Drehtisch bzw. keine Dreheinrichtung zum Schwenken der elektrischen Maschine in eine gewünschte Montageposition erforderlich.

Nach einer besonders vorteilhaften Weiterbildung der Erfindung ist vorgesehen, dass mit dem Betrieb der elektrischen Maschine, bei dem der Stator aus der vorgegebenen Montageposition in die weitere Montageposition um den Rotor rotiert, eine Funktionsprüfung der elektrischen Maschine durchgeführt wird. Damit wird die Bestromung des Stators zum Verdrehen desselben in eine weitere Montagposition gleichzeitig zum Überprüfen der Funktion der elektrischen Maschine im Sinne einer Endmontagekontrolle verwendet. Bei einer solchen Endmontagekontrolle kann der Drehbetrieb, die Drehrichtung, die Sensorik usw. überprüft werden.

Des Weiteren hat sich als vorteilhaft erwiesen, wenn eine Lageerkennung des Stators mittels Lagesensoren der elektrischen Maschine durchgeführt wird. Die Nutzung der maschineninternen Sensoren erfordert keine externen Sensoren zur Lageerkennung. Ferner ist es auch möglich, mittels außerhalb der elektrischen Maschine angeordneten Sensoren die Lageerkennung des Stators durchzuführen.

Vorzugsweise erfolgt der Betrieb der elektrischen Maschine als Motor durch Bestromen einer Drehstromwicklung des Stators. Mittels einer solchen Drehstromwicklung wird ein 3-Phasen-Drehfeld mit niedriger Frequenz erzeugt.

Das erfindungsgemäße Verfahren ist vorteilhaft für Drehfeldmaschinen, vorzugsweise für Synchron- oder Asynchronmaschinen verwendbar.

Die Erfindung wird nachfolgend anhand eines Ausführungsbeispiels unter Bezugnahme auf die beigefügten Figuren ausführlich beschrieben. Es zeigen:
- Figur 1: eine schematische Darstellung einer Anordnung einer Drehfeldmaschine auf einer Montageinrichtung in einer vorgegebenen Montageposition,
- Figur 2: eine schematische Darstellung der Anordnung nach Figur 1 mit einem an der Drehfeldmaschine verbauten Anbauteil,
- Figur 3: eine schematische Darstellung der Anordnung nach Figur 1 in einer weiteren Montageposition des Drehfeldmaschine, und
- Figur 4: eine schematische Darstellung der Anordnung nach Figur 3 mit einem an der Drehfeldmaschine verbauten weiteren Anbauteil.

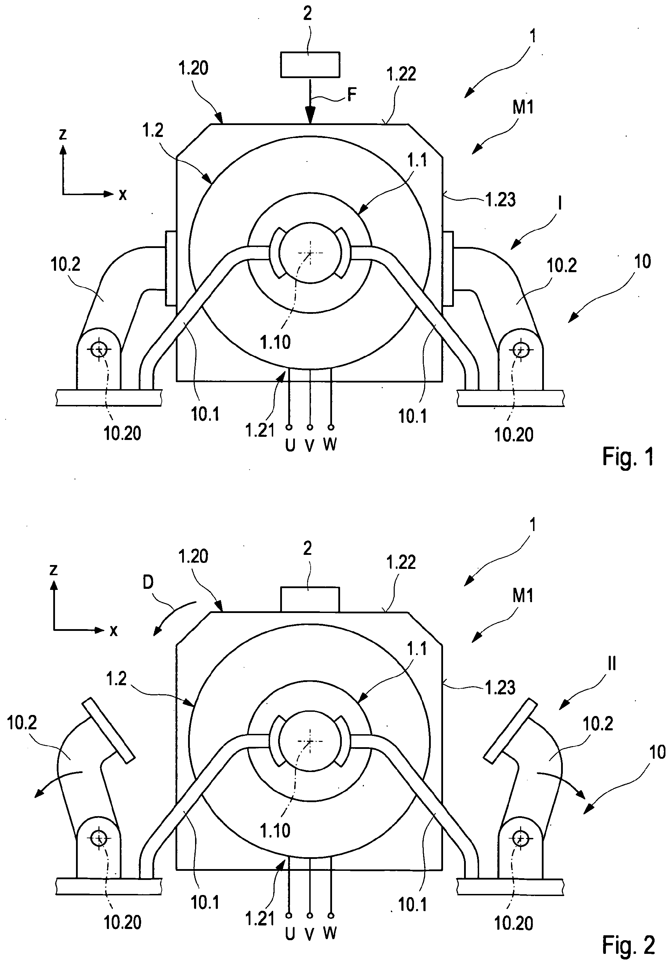

Die Figuren 1 bis 4 zeigen eine auf einer Montageeinrichtung 10 montierte elektrische Maschine 1. Diese Montageeinrichtung 10 dient dazu, Anbauteile 2 und 3 an die elektrische Maschine 1 zu montieren. Die elektrische Maschine 1 stellt eine als Synchron- oder Asynchronmaschine ausgebildete Drehfeldmaschine dar und umfasst einen eine Rotorachse 1.10 aufweisenden Rotor 1.1 und einen in einem Statorgehäuse 1.20 angeordneten Stator 1.2. Ferner umfasst der Stator 1.2 eine als Drehfeldwicklung bzw. Drehstromwicklung ausgeführte Statorwicklung 1.21, die bspw. ein 3-Phasen-Drehfeld erzeugt.

Die elektrische Maschine 1 wird auf der Montageeinrichtung 10 montiert, indem die Rotorachse 1.10 des Rotors 1.1 drehfest mit einer Lagervorrichtung 10.1 der Montageeinrichtung 10 verbunden wird. Dies hat zur Folge, dass bei einer Bestromung mit einem 3-Phasenstrom sich nicht der Rotor 1.1 gegenüber dem Stator 1.2 dreht, sondern der Stator 1.2 gegenüber dem Rotor 1.1 in Rotation versetzt wird. Um den Stator 1.2 in einer vorgegebenen Montageposition zu fixieren, weist die Montageeinrichtung 10 eine Klemmvorrichtung 10.2 auf, die bspw. mittels Klammern das Statorgehäuse 1.20 in der vorgegebenen Montageposition festhält, um dadurch ein Drehen des Stators 1.2 aus der vorgegebenen Montageposition zu verhindern. Diese Klemmvorrichtung 10.2 ist zwischen einer das Statorgehäuse 1.20 festklemmenden Klemmposition I und einer das Statorgehäuse 1.20 freigebenden Nichtklemmposition II um Drehachsen 10.20 schwenkbar.

Die in Figur 1 gezeigte Montageposition M1 des Stators 1.2 zeichnet sich dadurch aus, dass das von einem Monteur zu verbauende Anbauteil 2 von oben, d.h. in der in Figur 1 dargestellten z-Richtung an eine Montagefläche 1.22 des Statorgehäuses 1.20 geführt werden kann, die Fügerichtung F somit der Schwerkraft bzw. der Gewichtskraft des Anbauteils 2 entspricht. Während des Montagevorganges verbleibt das Statorgehäuse 1.20 in der Montageposition M1, da es von der Klemmvorrichtung 10.2 in dieser Montageposition I fixiert ist.

Nachdem die Montage des Anbauteils 2 an dem Statorgehäuse 1.20 beendet ist, wird die Klemmvorrichtung 10.2 gelöst, d.h. sie wird aus der Klemmposition I in die Nichtklemmposition II verschwenkt, wie dies in Figur 2 dargestellt ist. Gleichzeitig wird die Statorwicklung 1.21 mit einem 3-Phasenwechselstrom bestromt, so dass der Stator 1.2 in eine Drehrichtung D um den Rotor 1.1 gedreht wird. Hierfür wird ein 3-Phasenwechselstrom mit niedriger Frequenz, zum Beispiel von 0,5 Hz verwendet, um eine kleine Rotationsgeschwindigkeit des Stators 1.2 zusammen mit dem Statorgehäuse 1.20 um den Rotor 1.1 zu erreichen.

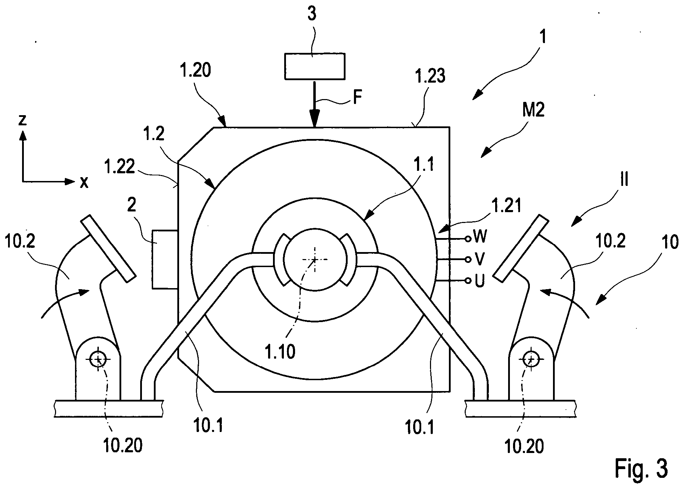

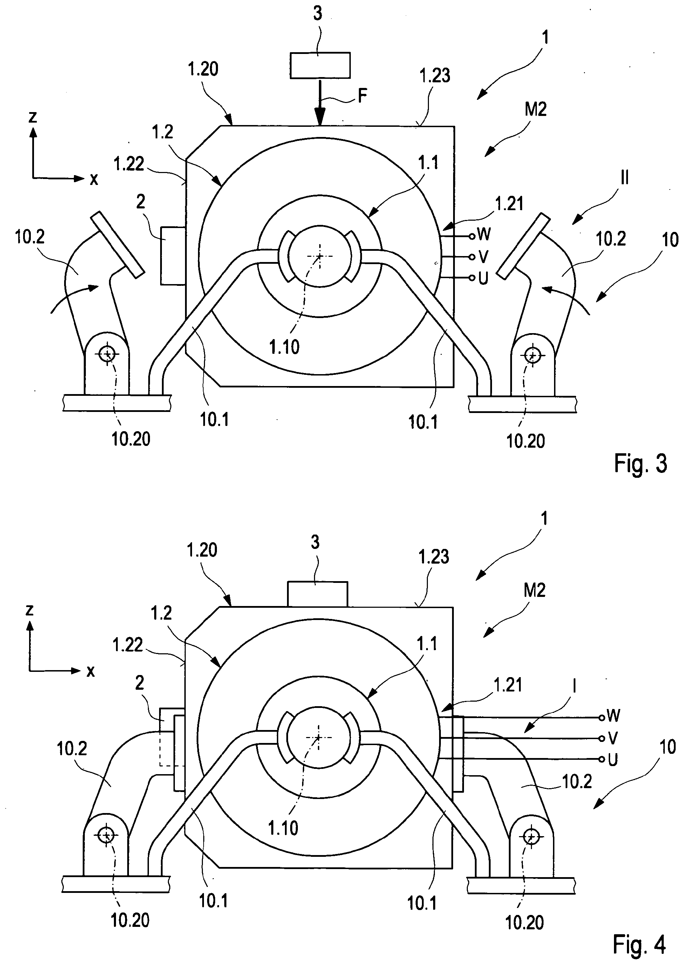

Die Bestromung der Statorwicklung 1.21 wird beendet, wenn der Stator 1.2 eine gegenüber der vorgegebenen Montageposition M1 eine bspw. um 90° verschwenkte weitere Montageposition M2 gemäß Figur 3 erreicht hat. Auch diese weitere Montageposition M2 zeichnet sich durch eine für das weitere Anbauteil 3 vorgesehene weitere Montagefläche 1.23 dadurch aus, dass der Monteur dieses weitere Anbauteil 3 von oben (z-Richtung), also mit einer in Richtung der Schwerkraft bzw. Gewichtskraft des Anbauteils 3 verlaufenden Fügerichtung F an der weiteren Montagefläche 1.23 montieren kann.

Gleichzeitig mit dem Erreichen der weiteren Montageposition M1 des Stators 1.2 wird die Klemmvorrichtung 10.2 in die Klemmposition I verschwenkt, wie dies in Figur 4 dargestellt ist. Damit wird das Statorgehäuse 1.20 in dieser weiteren Montageposition M2 festgeklemmt und der Monteur kann das weitere Anbauteil 3 an dem Statorgehäuse 1.20 verbauen. Die elektrische Maschine 1 mit dem verbauten Anbauteil 3 zeigt Figur 4.

Die während der Bestromung der Statorwicklung 1.21 sich einstellende Position des Stators 1.2 wird mit Sensoren der elektrischen Maschine 1 detektiert, so dass die Bestromung der Statorwicklung 1.21 zum richtigen Zeitpunkt unterbrochen werden kann. Anstelle der Sensorik der elektrischen Maschine 1 können auch externe Sensoren, die an der Montageeinrichtung 10 angeordnet sind, zur Detektion der Position des Stators 1.2 verwendet werden.

Mit dem Betrieb der elektrischen Maschine 1, bei dem der Stator 1.2 aus der vorgegebenen Montageposition M1 in die weitere Montageposition M2 um den Rotor 1.1 gedreht wird, wird eine Funktionsprüfung der elektrischen Maschine 1 durchgeführt. Damit wird die Bestromung des Stators 1.2 zum Verdrehen desselben in die weitere Montagposition M2 gleichzeitig zum Überprüfen der Funktion der elektrischen Maschine 1 im Sinne einer Endmontagekontrolle verwendet. Bei einer solchen Endmontagekontrolle werden der Drehbetrieb, die Drehrichtung, die Sensorik, elektrische und mechanische Parameter usw. der elektrischen Maschine 1 überprüft.

Zum Verbauen von weiteren Anbauteilen kann der Vorgang des Öffnens der Klemmvorrichtung 10.2, der Rotation des Stators 1.2 zusammen mit dem Statorgehäuse 1.20 in eine weitere Montageposition und das anschließende Klemmen des Stators 1.2 in der weiteren Montageposition natürlich mehrmals wiederholt werden.

### Bezugszeichen

- 1: elektrische Maschine, Drehfeldmaschine
- 1.1: Rotor der elektrischen Maschine 1
- 1.10: Rotorachse des Rotors 1.1
- 1.2: Stator der elektrischen Maschine 1
- 1.20: Statorgehäuse
- 1.21: Statorwicklung des Stators 1.2
- 1.22: Montagefläche des Statorgehäuses 1.20
- 1.23: weitere Montagefläche des Statorgehäuses 1.20

- 2: Anbauteil
- 3: weiteres Anbauteil

- 10: Montageeinrichtung
- 10.1: Lagervorrichtung der Montageeinrichtung 10
- 10.2: Klemmvorrichtung der Montageeinrichtung 10
- 10.20: Drehachse der Klemmvorrichtung 10.2

## Patentansprüche

1. Verfahren zur Montage von Anbauteilen an einer einen in einem Statorgehäuse (1.20) angeordneten Stator (1.2) und einen Rotor (1.1) aufweisenden elektrischen Maschine (1),
**dadurch gekennzeichnet, dass**
- die elektrische Maschine (1) auf einer Montageeinrichtung (10) montiert wird, indem der Rotor (1.1) drehfest mit einer Lagervorrichtung (10.1) der Montageeinrichtung (10) verbunden wird,
- zum Montieren wenigstens eines Anbauteiles (2) der Stator (1.2) über das Statorgehäuse (1.20) mittels einer Klemmeinrichtung (10.2) der Montageeinrichtung (10) in einer vorgegebenen Montageposition (M1) lösbar fixiert wird,
- das Anbauteil (2) an dem Stator (1.2) montiert wird,
- zum Montieren wenigstens eines weiteren Anbauteils (3) in einer weiteren Montageposition (M2) die Klemmeinrichtung (10.2) gelöst und die elektrische Maschine (1) mit einer solchen Zeitdauer als Motor betrieben wird, bis der Stator (1.2) zusammen mit dem Statorgehäuse (1.20) durch Rotation (D) gegenüber dem mit der Lagervorrichtung (10.1) drehfest verbundenen Rotor (1.1) die weitere Montageposition (M2) erreicht hat,
- der Stator (1.2) über das Statorgehäuse (1.20) in der weiteren Montageposition (M2) mittels der Klemmeinrichtung (10.2) fixiert wird, und
- das weitere Anbauteil (3) an dem Stator (1.2) montiert wird.

2. Verfahren nach Anspruch 1,
**dadurch gekennzeichnet, dass** mit dem Betrieb der elektrischen Maschine (1), bei dem der Stator (1.2) aus der vorgegebenen Montageposition (M1) in die weitere Montageposition (M2) um den Rotor (1.1) rotiert, eine Funktionsprüfung der elektrischen Maschine (1) durchgeführt wird.

3. Verfahren nach Anspruch 1 oder 2,
**dadurch gekennzeichnet, dass** eine Lageerkennung des Stators (1.2) mittels Lagesensoren der elektrischen Maschine (1) oder mittels außerhalb der elektrischen Maschine (1) angeordneten Sensoren durchgeführt wird.

4. Verfahren nach einem der vorhergehenden Ansprüche,
**dadurch gekennzeichnet, dass** der Betrieb der elektrischen Maschine (1) als Motor durch Bestromen einer Drehstromwicklung (1.21) des Stators (1.2) erfolgt.

5. Verfahren nach Anspruch 4,
**dadurch gekennzeichnet, dass** mittels der Drehstromwicklung (1.21) ein 3-Phasen-Drehfeld mit niedriger Frequenz erzeugt wird.

6. Verfahren nach einem der vorhergehenden Ansprüche,
**dadurch gekennzeichnet, dass** die elektrische Maschine als Drehfeldmaschine (1), vorzugsweise als Synchron- oder Asynchronmaschine ausgebildet wird.

## Claims

1. Method for mounting attachment parts to an electric machine (1) comprising a stator (1.2) arranged in a stator housing (1.20) and a rotor (1.1),
**characterised in that**
- the electric machine (1) is mounted on an assembly device (10) by non-rotatably connecting the rotor (1.1) to a bearing device (10.1) of the assembly device (10),
- for mounting at least one mounting part (2) the stator (1.2) is detachably secured in a predefined installation position (M1) by the stator housing (1.20) by means of a clamping device (10.2) of the assembly device (10),
- the mounting part (2) is mounted on the stator (1.2),
- for mounting at least one further mounting part (3) in a further installation position (M2) the clamping device (10.2) is released and the electric machine (1) is operated as a motor for a time period sufficient for the stator (1.2) together with the stator housing (1.20) to rotate (D) in relation to the rotor (1.1) that is non-rotatably connected to the bearing device (10.1) until reaching the further installation position (M2),
- the stator (1.2) is secured in the further installation position (M2) by the stator housing (1.20) by means of the clamping device (10.2), and
- the further attachment part (3) is mounted on the stator (1.2).

2. Method according to claim 1, **characterised in that** during operation of the electric machine (1), while the stator (1.2) rotates about the rotor (1.1) from the predefined installation position (M1) to the further installation position (M2), the electric machine (1) is checked for operativeness.

3. Method according to claim 1 or 2, **characterised in that** a position of the stator (1.2) is detected by means of position sensors of the electric machine (1) or by means of sensors located outside the electric machine (1).

4. Method according to any of the preceding claims, **characterised in that** the electric machine (1) is operated as a motor by energizing a three-phase winding (1.21) of the stator (1.2).

5. Method according to claim 4, **characterised in that** a three-phase rotating field with a low frequency is generated by means of the three-phase winding (1.21).

6. Method according to any of the preceding claims, **characterised in that** the electric machine is configured as polyphase machine (1), preferably as synchronous machine or asynchronous machine.

## Revendications

1. Procédé de montage de pièces rapportées sur une machine électrique (1) présentant un stator (1.2) agencé dans un boîtier de stator (1.20) et un rotor (1.1), **caractérisé en ce que**
- la machine électrique (1) est montée sur un dispositif de montage (10) en raccordant le rotor (1.1) solidaire en rotation à un dispositif de palier (10.1) du dispositif de montage (10),
- pour monter au moins une pièce rapportée (2), le stator (1.2) est fixé de manière amovible en position de montage préétablie (M1) sur le boîtier de stator (1.20) au moyen d'un dispositif de serrage (10.2) du dispositif de montage (10),
- la pièce rapportée (2) est montée sur le stator (1.2),
- pour monter au moins une autre pièce rapportée (3) dans une autre position de montage (M2), le dispositif de serrage (10.2) est desserré et la machine électrique (1) est mise en marche en tant que moteur pendant un intervalle de temps tel que le stator (1.2) ait atteint l'autre position de montage (M2) conjointement avec le boîtier de stator (1.20) par rotation (D) vis-à-vis du rotor (1.1) raccordé solidaire en rotation au dispositif de palier (10.1),
- le stator (1.2) est fixé sur le boîtier de stator (1.20) dans l'autre position de montage (M2) au moyen du dispositif de serrage (10.2) et
- l'autre pièce rapportée (3) est montée sur le stator (1.2).

2. Procédé selon la revendication 1,
**caractérisé en ce que**
un test de fonctionnement de la machine électrique (1) est effectué avec la mise en marche de la machine électrique (1), dans laquelle le stator (1.2) est soumis à une rotation autour du rotor (1.1) de la position de montage préétablie (M1) dans l'autre position de montage (M2).

3. Procédé selon la revendication 1 ou 2,
**caractérisé en ce que**
une reconnaissance de position du stator (1.2) est effectuée au moyen de capteurs de position de la machine électrique (1) ou au moyen de capteurs agencés en dehors de la machine électrique (1).

4. Procédé selon l'une quelconque des revendications précédentes,
**caractérisé en ce que**
la mise en marche de la machine électrique (1) se fait en tant que moteur par alimentation d'un enroulement de courant triphasé (1.21) du stator (1.2).

5. Procédé selon la revendication 4,
**caractérisé en ce que**
un champ rotatif triphasé de faible fréquence est produit au moyen de l'enroulement de courant triphasé (1.21).

6. Procédé selon l'une quelconque des revendications précédentes,
**caractérisé en ce que**
la machine électrique se présente sous la forme d'un générateur à induction (1), de préférence sous la forme d'une machine synchrone ou asynchrone.
